# EUROPEAN PATENT SPECIFICATION

(11) **EP 2 787 508 B1**
(45) Date of publication and mention of the grant of the patent: **11.09.2019**
(21) Application number: 12790779.8
(22) Date of filing: 09.11.2012
(51) Int. Cl.: G11C 19/28

(54) **DRIVE CIRCUIT, SHIFT REGISTER, GATE DRIVE, ARRAY SUBSTRATE AND DISPLAY DEVICE**
TREIBERSCHALTUNG, SCHIEBEREGISTER, GATEANSTEUERUNG, ARRAYSUBSTRAT UND ANZEIGEVORRICHTUNG
CIRCUIT D'ATTAQUE, REGISTRE À DÉCALAGE, CIRCUIT D'ATTAQUE DE GRILLE, SUBSTRAT DE RÉSEAU ET DISPOSITIF D'AFFICHAGE

(30) Priority: 25.11.2011 CN 201110381991
(43) Date of publication of application: 08.10.2014
(73) Proprietor: BOE Technology Group Co., Ltd., Beijing 100016 (CN); Hefei BOE Optoelectronics Technology Co., Ltd., Hefei, Anhui 230012 (CN)
(72) Inventor: MA, Rui, Beijing 100176 (CN); SHAO, Xianjie, Beijing 100176 (CN); WANG, Guolei, Beijing 100176 (CN); HU, Ming, Beijing 100176 (CN); LIM, Byung Cheon, Beijing 100176 (CN); TU, Zhizhong, Beijing 100176 (CN)
(74) Representative: Brötz, Helmut
(86) International application number: PCT/CN2012/084399
(87) International publication number: WO 2013/075590

(56) References cited:
- CN-A- 1 862 650
- CN-A- 101 645 308
- CN-A- 101 645 308
- CN-A- 102 654 986
- CN-A- 102 708 778
- US-A1- 2006 164 376
- US-A1- 2008 088 555
- US-A1- 2008 219 401
- US-A1- 2010 026 669
- US-A1- 2011 058 640

## Description

### TECHNICAL FIELD

The present disclosure relates to the field of liquid crystal display, in particular, to a driving circuit, a shifting register, a gate driver, an array substrate, and a display device.

### BACKGROUND

A Liquid Crystal Display (LCD) has advantages of light weight, thin in thickness, and low power consumption etc., and is widely used in the electronic products such as TVs, mobile phones, and displays and the like.

LCD comprises a pixel array in which pixels are arranged in horizontal and vertical directions, and when LCD displays an image, it outputs gate input signals via a gate driving circuit so as to scan the pixels row-by-row. The driving in LCD mainly comprises a gate driver and a data driver, wherein the data driver latches the input data for display sequentially according to timings of a clock signal, converts the same into analog signals and input the analog signals into the data lines in the liquid crystal panel; the gate driver converts the input clock signal by a shifting register into voltages for switching on/ switching off the gate lines, and applies the same to the gate lines in the liquid crystal panel. The shifting register in the gate driver is used for generating the scanning signals scanning the gate lines.

The shifting register is a common semi-conductor device, and is often used in the LCD. The shifting register in the LCD is an n-stage shifting register. Each of the gate lines in the LCD is electrically connected to a driving circuit at a stage of the shifting register. When the LCD is in operation, the driving circuit at each stage of the shifting register outputs driving signal to the corresponding row of the liquid crystal panel.

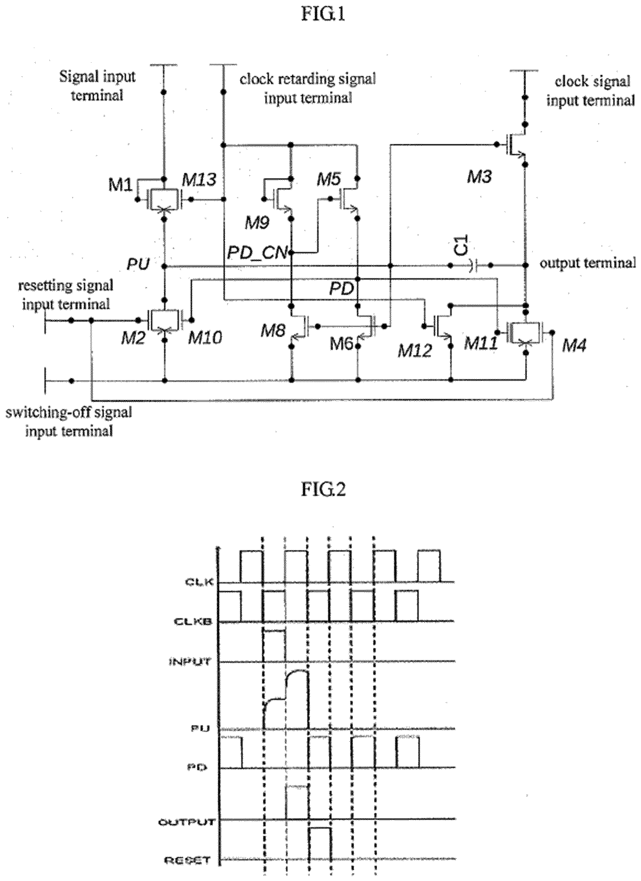

Fig.1 is a schematic diagram for illustrating the driving circuit at each stage of an existing shifting register. As shown in Fig.1, the driving circuit includes a pull-up module, a resetting module, a pull-up driving module, a pull-down module, and a pull-down driving module.

The pull-up module comprises a Thin Film Transistor (TFT) M3. The TFT M3 has a gate under the control of a pull-up node PU, a drain connected to a clock signal input terminal CLK, and a source connected to an output terminal Output. When the TFT M3 is turned on by the pull-up node PU, the signal input from the CLK is output to the output terminal Output.

The resetting module comprises a TFT M2 and a TFT M4. The TFT M2 has a gate under the control of a resetting signal input terminal RESET, a drain connected to the pull-up node PU, and a source connected to a switching-off signal input terminal Vss; and the TFT M4 has a gate under the control of the RESET, a drain connected to the OUTPUT, and a source connected to the Vss. The TFTs M2 and M4 turn on when a resetting signal input from the RESET, i.e., an output signal from the next stage, appears, and the pull-up node PU and the OUTPUT are reset to pull down their signals to a switching-off voltage.

The pull-up driving module comprises a TFT M1, a TFT M13 and a capacitor C1. The TFT M1 has a drain and a gate connected together and further connected to a signal input terminal INPUT, and a source connected to the pull-up node PU; the TFT M13 has a gate under the control of a clock retarding signal at a clock retarding signal input terminal CLKB, a drain connected to the INPUT, and a source connected to the pull-up node PU; and the capacitor C1 has one terminal connected to the pull-up node PU, and the other terminal connected to the OUTPUT. When the signal input at the INPUT and the clock retarding signal at the CLKB are at a high level simultaneously, the TFTs M1 and M13 turn on, and one plate of the capacitor C1 is charged, causing the pull-node PU to be at a high level and the TFT M3 to turn on. When the clock signal input from the CLK at next timing appears, the potential of the pull-up node PU (i.e., the gate of the TFT M3) increases due to the bootstrapping effect, resulting in an effect of the threshold voltage compensation.

The pull-down module comprises a TFT M10, a TFT M11 and a TFT M12. The TFT M12 has a gate connected to the CLKB, a source connected to the Vss, and a drain connected to the OUTPUT. The TFT M12 is controlled by the clock retarding signal, and when a high level appears at the CLKB, the TFT M12 turns on and pulls the OUTPUT down, decreasing the output noise of the OUTPUT to ensure the stability of the output signal. The TFT M10 and TFT M11 are controlled by the node PD in the pull-down driving module; when the node PD is at a high level, the TFTs M10 and M11 turn on to pull the pull-up node PU and the OUTPUT down, decreasing the output noise of the OUTPUT to ensure the stability of the output signal.

The pull-down driving module comprises a TFT M5, a TFT M6, a TFT M8 and a TFT M9, mainly for controlling the output potential of the node PD so as to drive the pull-down module.

Fig. 2 is a timing sequence chart of a driving circuit at each stage of the existing shifting register. As shown in Fig.2, the operating principle of the above shifting register is as follows:

In a first phase, when the INPUT is at a high level and the CLKB is also at a high level, the signal at the INPUT is the output signal of the previous stage, and the TFT M1 turns on; since the CLKB is at a high level, the TFT M13 turns on, and the high level signal at the INPUT charges the C1, so that the potential of the pull-up node PU is pulled up, and at the same time, the TFT M8 and the TFT M6 turn on; the high level signal at the CLKB also turns on the TFT M9 and the TFT M5. By designing the transistors in size, the potential of the node PD can be controlled at a low level at this time, so that the TFT M10 and TFT M11 turn off, preventing the two transistors from performing pull-down, to ensure the stability of the output signal.

In a second phase, when the INPUT is at a low level and the CLKB is also at a low level, the TFTs M1 and M13 turn off, and the pull-up node PU remains at a high level and the TFT M3 remains on. At this time, since the CLK is at a high level, the voltage at the pull-up node PU rises up due to the bootstrapping effect, and finally a driving signal is output to the OUTPUT.

In a third phase, the clock retarding signal terminal CLKB is at a high level and the signal at the resetting terminal RESET is also at a high level, wherein the signal at the RESET is the output signal at the OUTPUT at the next stage. The high level signal at the CLKB turn on the TFTs M9 and M5, and the node PD is at a high level to turn on the TFTs M10 and M11, and thus a switching-o ff signal is transmitted to the pull-up node PU and the OUTPUT; the high level signal at the resetting signal input terminal RESET turns on the TFTs M2 and M4 to transmit a switching-off signal to the pull-up node PU and the OUTPUT.

In a fourth phase, the signal at the CLK is at a high level. At the moment, since the TFT M3 turns off, the high level signal at the CLK would not be transmitted to the OUTPUT, and the output signal at the OUTPUT remains at the low level appearing at the last timing.

In a fifth phase, the signal at the CLKB is at a high level. At the moment, the high level signal at the CLKB turns on the TFTs M9, M5 and M12, so that the node PD is at a high level, and then the TFTs M10 and M11 turn on to transmit a switching-o ff signal to the OUTPUT and the pull-up node PU.

Afterwards, before the first phase restarts, the fourth and fifth phases repeat in order.

In the prior art, both the clock input signal at the CLK and the clock retarding signal at the CLKB can be a high voltage at about 27V. Therefore, from the above operating principle, when the input signal at the CLK is at high level, in the case of the ideal logic timing, a coupling voltage is generated at the pull-up node PU due to the coupling effect of the coupling capacitor between the gate and the drain of the TFT, which results in the noise of the output signal. As shown in Fig.2, when a high level signal at the CLK appears, the CLKB is at a low level; at the timings other than one at which a high level signal appears at the resetting signal terminal RESET, the potential at the node PD is the same as that at the CLKB, i.e., a low level, and thus the TFTs M10 and M11 turn off and the noises at the pull-up node PU and the OUTPUT can not be discharged, so that larger noises would be generated stage-by-stage. Since driving circuits at individual stages of a shifting register in a gate driver correlates with each other, an output signal of the present stage serves not only as an input signal of the next stage, but also as a resetting signal of the previous stage; therefore, each stage would affect the operation of the whole shifting register.

In the practical design for the shifting register, by designing the TFTs M6, M5, M8 and M9 in size, it can achieve the following solution: when a high level appears at the INPUT and the CLK simultaneously, the node PD is kept at a low level, and the TFTs M10 and M11 turn off to ensure the appropriate output signal to be output; when a low level appears at the INPUT and a high level appears at the CLKB, the node PD is designed as being at a high level, and the TFTs M10 and M11 turn on so as to output an appropriate switching-off signal to the pull-up node PU and the OUTPUT; when a low level appears at the INPUT and the CLKB, the node PD is designed as being at a middle level, and the TFTs M10 and M11 turn on so as to pull down the coupling voltage generated by the clock signal at the CLK, decreasing the noises at the pull-up node and the output terminal. The above solution has an advantage of no need for modifying the circuit of the existing shifting register, but has a drawback that the TFTs M10 and M11 remain on for a long time since the node PD is designed as being at a high level or a middle level. The threshold voltage of the TFT depends greatly on the voltage applied to the gate of the TFTs and the time for which the voltage being applied, and under the condition that a voltage is applied to the gate of the TFT for a long time, the threshold voltage of the TFT drifts enormously, which resulting in an immense reduction of the lifespan of the shifting register in a gate driver, affecting the operation of the whole gate driver.
From US2011/0058640 A1 it is known a shift register unit and a gate drive device for a liquid crystal display. US2008/0088555 A1 discloses a gate driving circuit and display apparatus having the same. From US2010/0026669 A1 it is known a gate driving circuit, a display device having the same and a method for manufacturing the display device. US 2008/0219401 A1 refers to a shift register circuit and an image display apparatus containing the same. From CN 101645308 A it is known a shift register comprising multiple stage circuit units.

### SUMMARY

### (I) The technical problem to be solved

The technical problem to be solved by the disclosure is to provide a driving circuit, a shifting register, a gate driver, an array substrate and a display device for effectively removing the defect of the threshold voltage drifting due to the gate being applied to a bias voltage stress, and decreasing the noise of the output voltage.

### (II) Technical solution

In order to solve the above problem the disclosure provides a driving circuit according to appended claim 1. Preferred aspects are defined in the dependent claims 2-6.

### (III) Beneficial Effect

The disclosure proposes an addition of a pull-down module on the basis of the stage of the existing shifting register to decrease the threshold voltage drifting of the TFT, and decrease the noise of the output voltage, and thus the lifespan of the driving circuit at each stage in the shifting register, of the whole shifting register, of the gate driver, of the array substrate and of the liquid crystal display are extended, ensuring the operation signal to be output in a high reliability. In addition, on the basis of the stage of the prior shifting register, when the clock signal appears at the CLK, the coupling voltage at the pull-up node PU is discharged to decrease the noise thereof, and in the meantime, the output node is also discharged to reduce the noise of the output signal, and thus improving the stability of the driving circuit at each stage in the shifting register, of the whole shifting register, of the gate driver, of the array substrate and of the liquid crystal display.

### BRIEF DESCRIPTION OF THE DRAWINGS

Fig.1 is a schematic circuit diagram of a driving circuit at each stage in an existing shifting register;
Fig.2 is a logic timing sequence chart of the driving circuit at each stage in the existing shifting register;
Fig.3 is a block diagram of the structure of a driving circuit at each stage in a shifting register according to an embodiment of the present disclosure;
Fig.4 is a schematic circuit diagram of a driving circuit at each stage in a shifting register according to an embodiment of the present disclosure; and
Fig. 5 is a schematic circuit diagram of a second pull-down module in the driving circuit at each stage in the shifting register according to an embodiment of the present disclosure.

### DETAILED DESCRIPTION

Hereinafter, the technical solutions in the embodiments of the disclosure are described clearly and fully with reference to the attached drawings in the embodiments of the disclosure. Obviously, the embodiments as described are only parts of embodiments rather than all the possible embodiments of the disclosure..

A driving circuit, a shifting register, a gate driver, an array substrate and a display device proposed in the disclosure are illustrated as follows by means of the attached drawings and the embodiments.

According to the disclosure, on the basis of the driving circuit at each stage of the existing shifting register, a pull-down module is incorporated. When a clock input signal appears at the CLK, the coupling voltage at the pull-up node PU (i.e., the noise at the pull-up node PU) is discharged to decrease the noise, and simultaneously the output terminal is also discharged to decrease the noise of the output signal, and to increase the stability of the stage in the shifting register; in the meantime, by the incorporated pull-down module, the time for which the TFTs in the prior pull-down module are turned on and the time for which the gates are applied to a bias voltage stress are decreased, and thus the lifespans of the TFTs are extended, and the lifespan of the driving circuit at each stage in the shifting register, of the whole shifting register, of the gate driver, even of the array substrate and of the liquid crystal display are extended.

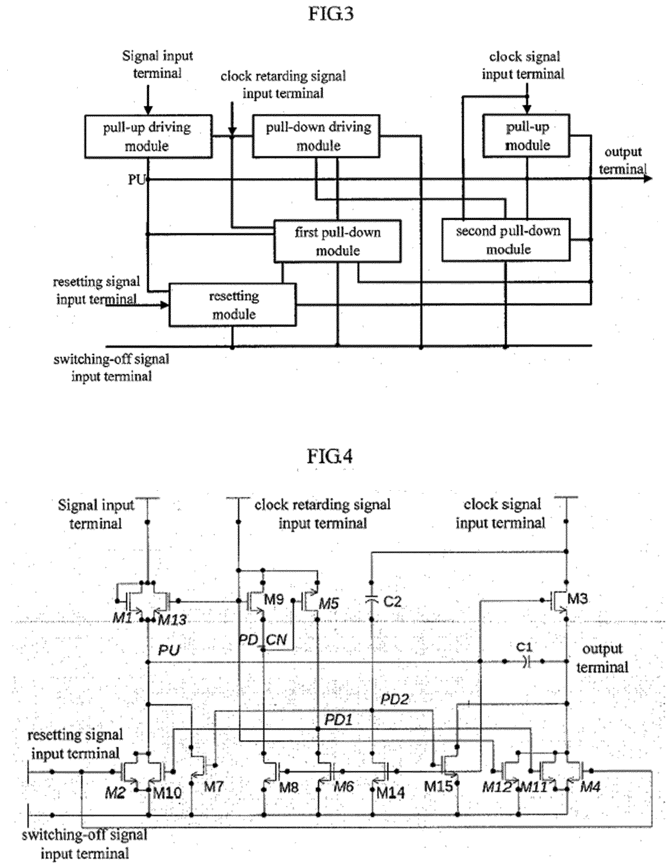

As shown in Figs. 3-4, the driving circuit at each stage in the shifting register according to an embodiment of the disclosure includes: a pull-up module, a first pull-down module, a second pull-down module, a pull-up driving module, a pull-down driving module and a resetting module, wherein the pull-up module, the first pull-down module, the pull-up driving module, the pull-down driving module and the resetting module might be the same as the corresponding parts in the driving circuit at each stage in the existing shifting register. Moreover, those skilled in the art should understand that, the pull-up module, the first pull-down module, the pull-up driving module, the pull-down driving module and the resetting module in the driving circuit at each stage in the shifting register according to the embodiment of the disclosure may differ from those in the driving circuit at each stage in the existing shifting register, so long as they achieve the same functions.

The pull-up module outputs a driving signal to the output terminal OUTPUT according to a signal at a pull-up node PU and a signal input from a clock signal input terminal CLK.

The pull-up driving module controls the signal at the pull-up node PU to drive the pull-up module according to a signal input from a signal input terminal INPUT and a signal input from a clock retarding signal input terminal CLKB.

The first pull-down module outputs a switching-off signal to the output terminal OUTPUT according to the signal input from the clock retarding signal input terminal CLKB and a signal at a pull-down node PD1.

The second pull-down module, when the signal input from the signal input terminal INPUT is at a low level, outputs the switching-off signal to the pull-up node PU and the output terminal OUTPUT according to the signal input from the clock signal input terminal CLK.

The pull-down driving module controls the signal at the pull-down node PD1 to drive the first pull-down module according to the signal input from the clock retarding signal input terminal CLKB and the signal at the pull-up node PU.

The resetting module outputs the switching-off signal to the pull-up node PU and the output terminal OUTPUT according to the signal input from the resetting signal input terminal RESET.

In the driving circuit at each stage of the shifting register in the embodiment, when the signal input from the INPUT is at a high level, the signal input from the CLK is also at a high level, and the signal input from the CLK and that from the CLKB are opposite in phase. In addition, the signal input from the INPUT is the signal output from the OUTPUT at its previous stage, and the signal input from the RESET is the signal output from the OUTPUT at its next stage.

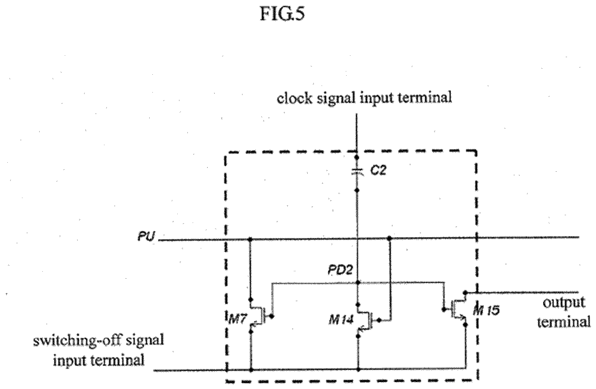

As shown in Fig. 5, the second pull-down module further includes a first thin film transistor(TFT) M14, a second TFT M7, a third TFT M15 and a capacitor C2, wherein the first TFT M14 has a gate connected to the pull-up node PU, a drain connected to one plate of the capacitor C2, and a source connected to a switching-off signal input terminal VSS; the other plate of the capacitor C2 is connected to the clock signal input terminal CLK; the second TFT M7 has a gate connected to a gate of the third TFT M15 and the node PD2, a drain connected to the pull-up node PU, and a source connected to the switching-off signal input terminal VSS, wherein the node PD2 is further connected to said plate of the capacitor C2 and the drain of the TFT M14; and the third TFT M15 has a drain connected to the output terminal OUTPUT and a source connected to the switching-off signal input terminal VSS.

The function of the second pull-down module is further illustrated with reference to the timing sequence chart of the shifting register shown in Fig.2:
(1) when the signal input from the signal input terminal INPUT is at a high level, the high level signal charges the capacitor C1, and the potential of the pull-up node PU is pulled up to turn on the first TFT M14, and then the potential of the node PD2 is pulled down to a switching-off signal level to turn off the second TFT M7 and the third TFT M15; when the signal input from the input signal terminal INPUT changes to a low level at the next timing and the signal input from the clock signal input terminal CLK is at a high level, the pull-up node PU still remains at a high level to turn on the first TFT M14, and the potential of the node PD2 is pull down to the switching-off signal level, and thus the second TFT M7 and the third TFT M15 turn off to ensure the output driving signal to be correct.
(2) After the two timings in the above (1), whenever a high level input signal appears at the clock signal input terminal CLK, the signal at the CLK can raise the potential of the node PD2 via the C2, and the second TFT M7 and the third TFT M15 turn on to transmit the switching-off signal to the pull-up node PU and the output terminal OUTPUT, so as to discharge the coupling noise generated by the high level at the clock signal input terminal CLK and ensure the output signal to be correct; at the meantime, this can cause the potential of the node PD1 (the node PD in Fig.2) to be at a low level to turn off the TFTs M10 and M11, decreasing the time for which the gates of the TFTs M10 and M11 are applied to a bias voltage stress, which thus extends the lifespan of the TFTs and further extends the lifespan of the stages in the shifting register.

The disclosure also provides a gate driver, the gate driver comprises a shifting register including a plurality of the driving circuits as mentioned above, wherein an input signal of the driving circuit at each stage is an output signal of its previous stage, and a resetting signal of each stage is an outputput signal of its next stage.

In the above gate driver, for the driving circuit at each stage of the shifting register in the gate driver, when the signal input terminal of the driving circuit is at a low level and the clock signal input terminal is at a high level, a switching-off signal is transmitted to the pull-up node and the signal output terminal.

Additionally, as shown in Fig.2, in a first phase, when the signal input terminal is at a high level, the clock retarding signal input terminal is at a high level, and the clock signal input terminal is at a low level, the output terminal outputs a low level;
in a second phase, when the signal input terminal is at a low level, the clock retarding signal input terminal is at a low level, and the clock signal input terminal is at a high level, the output terminal outputs a high level;
in a third phase, when the signal input terminal is at a low level, the clock retarding signal input terminal is at a high level, the clock signal input terminal is at a low level, and the resetting signal input terminal is at a high level, the output terminal outputs a low level;
in a fourth phase, when the signal input terminal is at a low level, the clock retarding signal input terminal is at a low level, and the clock signal input terminal is at a high level, the output terminal outputs a low level; and
in a fifth phase, when the signal input terminal is at a low level, the clock retarding signal input terminal is at a high level, and the clock signal input terminal is at a low level, the output terminal outputs a low level.

After the first phase, the second, third, fourth and fifth phases appear in order.

Subsequent to the fifth phase, the fourth phase and the fifth phase repeat until the first phase appears again.

The disclosure also provides an array substrate, wherein the array substrate includes a substrate, an active array arranged in the display area on the substrate, and the above gate driver arranged on one side of the substrate.

The disclosure also provides a display device including the above array substrate.

As the other parts in the gate driver, the array substrate and the display device are well known in the art, the details are omitted, and no limitation should be set on scope of the disclosure.

Although the disclosure is illustrated by taking a liquid crystal display as an example, it should be appreciated that the disclosure can be applied not only to the liquid crystal display, but also to the other displays which includes pixel arrays and is driven row-by-row or column-by-column, such as an OLED display device or AMOLED display device.

The above embodiments simply illustrate the disclosure rather than limit the disclosure in any way. The scope of protection of the present invention is defined by appended claims 1-6.

## Claims

1. A driving circuit comprising:
a pull-up module, for outputting a driving signal to an output terminal according to a potential at a pull-up node (PU) and a signal input from a clock signal input terminal;
a pull-up driving module, for controlling the potential at the pull-up node (PU) to drive the pull-up module according to a signal input from a signal input terminal and a signal input from a clock retarding signal input terminal;
a first pull-down module, for pulling down the potential at the pull-up node (PU) and a potential at the output terminal according to the signal input from the clock retarding signal input terminal and a potential at a first pull-down node (PD1);
a second pull-down module, when the signal input from the signal input terminal is at a low level, for pulling down the potential at the pull-up node (PU) and the potential at the output terminal according to the signal input from the clock signal input terminal;
a pull-down driving module, for controlling the potential at the first pull-down node (PD1) to drive the first pull-down module according to the signal input from the clock retarding signal input terminal and the potential at the pull-up node (PU);
a resetting module, for pulling down the potential at the pull-up node (PU) and the potential at the output terminal according to a signal input from a resetting signal input terminal;
wherein the driving circuit is configured such that, when the signal input from the signal input terminal is at a high level, the signal input from the clock retarding signal input terminal is also at a high level, and the signal input from the clock signal input terminal and that input from the clock retarding signal input terminal are opposite in phase; wherein
the first pull-down module comprises a first pull-down Thin Film Transistor TFT (M10) and a second pull-down TFT (M11), wherein the first pull-down Thin Film Transistor TFT (M10) and the second pull-down TFT (M11) are controlled by the first pull-down node (PD1), and when the first pull-down node (PD1) is at a high level, the first and second pull-down TFTs (M10, M11) are turned on so that the pull-up node (PU) and the output terminal are pulled down;
the second pull-down module further comprises: a third pull-down TFT(M14), a fourth pull-down TFT (M7), a fifth pull-down TFT (M15) and a capacitor (C2), wherein third pull-down TFT (M14) has a gate connected to the pull-up node (PU), a drain connected to a second pull-down node (PD2), and a source connected to a switching-off signal input terminal; a first plate of the capacitor (C2) is connected to the second pull-down node (PD2), and a second plate of the capacitor (C2) is connected to the clock signal input terminal; the fourth pull-down TFT (M7) has a gate connected to the second pull-down node(PD2), a drain connected to the pull-up node (PU), and a source connected to the switching-off signal input terminal; and the fifth pull-down TFT (M15) has a gate connected to the second pull-down node (PD2), a drain connected to the output terminal, and a source connected to the switching-off signal input terminal;
wherein the driving circuit is further configured such that, when the signal input terminal inputs a high level, the potential at the pull-up node (PU) is pulled up, and the potential at the first pull-down node(PD1) is pulled down, the first pull-down TFT (M10) and the second pull-down TFT (M11) are turned off, the third pull-down TFT (M14) is turned on so that the potential at the second pull-down node (PD2) is pulled down, and the fourth and fifth pull-down TFTs (M7, M15) are turned off; when the signal input terminal inputs a low level and the clock signal input terminal inputs a high level, the pull-up node (PU) is kept at a high level, and third pull-down TFT (M14) is kept ON, so that the second pull-down node (PD2) is kept at a low level, and the fourth and fifth pull-down TFTs (M7, M15) are turned off; the clock retarding signal input terminal inputs a low level, and the first pull-down node (PD1) is kept at a low level, and the first and second pull-down TFTs (M10, M11) are kept OFF;
after then the driving circuit is further configured such that, whenever the clock signal input terminal inputs a high level, the potential at the second pull-down node (PD2) is charged via the capacitor (C2), so that the fourth and fifth pull-down TFTs (M7, M15) are turned on, and the potential at the pull-up node (PU) and the potential at the output terminal are pulled down; meanwhile, the first pull-down node (PD1) is pulled down so that the fourth and fifth pull-down TFTs (M7, M15) are turned off.

2. A shifting register comprising the driving circuits according to claim 1 at a plurality of stages, wherein an signal input from the signal input terminal of the driving circuit at each stage is an signal output from the output terminal of the driving circuit at its previous stage, and a signal input from the resetting signal input terminal of the driving circuit at each stage is a signal output from the output terminal of the driving circuit at its next stage.

3. The shifting register according to claim 2, wherein, for the driving circuit at each stage, the shift register is configured such that, in a first phase, when the signal input terminal is at a high level, the clock retarding signal input terminal is at a high level, and the clock signal input terminal is at a low level, then the output terminal outputs a low level;
in a second phase, when the signal input terminal is at a low level, the clock retarding signal input terminal is at a low level, and the clock signal input terminal is at a high level, then the output terminal outputs a high level;
in a third phase, when the signal input terminal is at a low level, the clock retarding signal input terminal is at a high level, the clock signal input terminal is at a low level, and the resetting signal input terminal is at a high level, then the output terminal outputs a low level;
in a fourth phase, when the signal input terminal is at a low level, the clock retarding signal input terminal is at a low level, and the clock signal input terminal is at a high level, then the output terminal outputs a low level; and
in a fifth phase, when the signal input terminal is at a low level, the clock retarding signal input terminal is at a high level, and the clock signal input terminal is at a low level, then the output terminal outputs a low level,
wherein, after the first phase, the second, third, fourth and fifth phases appear in order; and
subsequent to the fifth phase, the fourth phase and the fifth phase repeat until the first phase appears again.

4. A gate driver comprising the shifting register according to claim 2 or 3.

5. An array substrate, including a substrate, an active array arranged in the display area on the substrate, and the gate driver according to claim 4 arranged on one side of the substrate.

6. A display device including the array substrate according to claim 5.

## Patentansprüche

1. Treiberschaltung, umfassend:
ein Pull-Up-Modul, zur Ausgabe eines Treibersignals an einen Ausgangsanschluss gemäß einem Potential an einem Pull-Up-Knoten (PU) und einem Signaleingang von einem Taktsignaleingangsanschluss;
ein Pull-Up-Treibermodul, zur Steuerung des Potentials an dem Pull-Up-Knoten (PU), um das Pull-Up-Modul zu steuern gemäß einem Signaleingang von einem Signaleingangsanschluss und einem Signaleingang von einem Taktretardierungssignaleingangsanschluss;
ein erstes Pull-Down-Modul, zum Herunterziehen des Signals an dem Pull-Up-Knoten (PU) und eines Potentials an dem Ausgangsanschluss gemäß dem Signaleingang von dem Taktretardierungssignaleingangsanschluss und einem Potential an einem ersten Pull-Down-Knoten (PD1);
ein zweites Pull-Down-Modul, das, wenn der Signaleingang von dem Signaleingangsanschluss bei einem niedrigen Level ist, bestimmt ist zum Herunterziehen des Potentials an dem Pull-Up-Knoten (PU) und des Potentials bei dem Ausgangsanschluss gemäß dem Signaleingang von dem Taktsignaleingangsanschluss;
ein Pull-Down-Treibermodul, zur Steuerung des Potentials an dem ersten Pull-Down-Knoten (PD1) zum Ansteuern des ersten Pull-Down-Moduls gemäß dem Signaleingang von dem Taktretardierungssignaleingangsanschluss und dem Potential bei dem Pull-Up-Knoten (PU);
ein Rückstellmodul, zum Herunterziehen des Potentials an dem Pull-Up-Knoten (PU) und des Potentials an dem Ausgangsanschluss gemäß einem Signaleingang von einem Rückstellsignaleingangsanschluss,
wobei die Treiberschaltung so konfiguriert ist, dass,
wenn der Signaleingang von dem Signaleingangsanschluss bei einem hohen Level ist, der Signaleingang von dem Taktretardierungssignaleingangsanschluss auch bei einem hohen Level ist, und der Signaleingang von dem Taktsignaleingangsanschluss und der Eingang von dem Taktretardierungssignaleingangsanschluss in entgegengesetzter Phase sind; wobei
das erste Pull-Down-Modul einen ersten Pull-Down-Dünnschichttransistor TFT (M10) und einen zweiten Pull-Down-TFT (M11) umfasst, wobei der erste Pull-Down-Dünnschichttransistor TFT (M10) und der zweite Pull-Down-TFT (M11) gesteuert werden mittels des ersten Pull-Down-Knotens (PD1), und wobei, wenn der erste Pull-Down-Knoten (PD1) bei einem hohen Level ist, die ersten und zweiten Pull-Down-TFTs (M10, M11) eingeschaltet werden, so dass der Pull-Up-Knoten (PU) und der Ausgangsanschluss heruntergezogen werden;
wobei das zweite Pull-Down-Modul außerdem umfasst: einen dritten Pull-Down-TFT (M14), einen vierten Pull-Down-TFT (M7), einen fünften Pull-Down-TFT (M15) und einen Kondensator (C2), wobei der dritte Pull-Down-TFT (M14) ein an den Pull-Up-Knoten (PU) angeschlossenes Gate, einen an einen zweiten Pull-Down-Knoten (PD2) angeschlossenen Drain und eine an einen Ausschaltsignaleingangsanschluss angeschlossene Source aufweist; wobei eine erste Platte des Kondensators (C2) an den zweiten Pull-Down-Knoten (PD2) angeschlossen ist und eine zweite Platte des Kondensators (C2) an den Taktsignaleingangsanschluss angeschlossen ist; wobei der vierte Pull-Down-TFT (M7) ein an den zweiten Pull-Down-Knoten (PD2) angeschlossenes Gate, einen an den Pull-Up-Knoten (PU) angeschlossenen Drain und eine an den Ausschaltsignaleingangsanschluss angeschlossene Source aufweist; und wobei der fünfte Pull-Down-TFT (M15) ein an den zweiten Pull-Down-Knoten (PD2) angeschlossenes Gate, einen an den Ausgangsanschluss angeschlossenen Drain und eine an den Ausschaltsignaleingangsanschluss angeschlossene Source aufweist;
wobei die Treiberschaltung außerdem so konfiguriert ist, dass,
wenn der Signaleingangsanschluss einen hohen Level eingibt, das Potential an dem Pull-Up-Knoten (PU) hochgezogen wird, und das Potenzial an dem ersten Pull-Down-Knoten (PD1) heruntergezogen wird, der erste Pull-Down-TFT (M10) und der zweite Pull-Down-TFT (M11) ausgeschaltet werden, der dritte Pull-Down-TFT (M14) eingeschaltet wird, so dass das Potential an dem zweiten Pull-Down-Knoten (PD2) heruntergezogen wird, und die vierten und fünften Pull-Down-TFTs (M7, M15) ausgeschaltet werden; wenn der Signaleingangsanschluss einen niedrigen Level eingibt und der Taktsignaleingangsanschluss einen hohen Level eingibt, der Pull-Up-Knoten (PU) bei einem hohen Level gehalten wird, und der dritte Pull-Down-TFT (M14) ON gehalten wird, so dass der zweite Pull-Down-Knoten (PD2) bei einem niedrigen Level gehalten wird, und die vierten und fünften Pull-Down-TFTs (M7, M15) ausgeschaltet werden; der Taktretardierungssignaleingangsanschluss gibt einen niedrigen Level ein, und der erste Pull-Down-Knoten (PD1) wird bei einem niedrigen Level gehalten, und die ersten und zweiten Pull-Down-TFTs (M10, M11) werden OFF gehalten;
wonach die Treiberschaltung außerdem so konfiguriert ist, dass,
wann auch immer der Taktsignaleingangsanschluss einen hohen Level eingibt, das Potential an dem zweiten Pull-Down-Knoten (PD2) mittels des Kondensators (C2) geladen wird, so dass die vierten und fünften Pull-Down-TFTs (M7, M15) eingeschaltet werden, und das Potential an dem Pull-Up-Knoten (PU) und das Potential an dem Ausgangsanschluss heruntergezogen werden; währenddessen wird der erste Pull-Down-Knoten (PD1) heruntergezogen, so dass die vierten und fünften Pull-Down-TFTs (M7, M15) ausgeschaltet werden.

2. Schieberegister, umfassend die Treiberschaltung gemäß Anspruch 1 an einer Mehrzahl von Stufen, wobei ein Signaleingang von dem Signaleingangsanschluss der Treiberschaltung an jeder Stufe ein Signalausgang von dem Ausgangsanschluss der Treiberschaltung an ihrer vorangehenden Stufe ist, und ein Signaleingang von dem Rückstellsignaleingangsanschluss der Treiberschaltung an jeder Stufe ein Signalausgang von dem Ausgangsanschluss der Treiberschaltung an ihrer nächsten Stufe ist.

3. Schieberegister gemäß Anspruch 2, wobei für die Treiberschaltung bei jeder Stufe das Schieberegister so konfiguriert ist, dass
in einer ersten Phase, wenn der Signaleingangsanschluss bei einem hohen Level ist, der Taktretardierungssignaleingangsanschluss bei einem hohen Level ist und der Taktsignaleingangsanschluss bei einem niedrigen Level ist, dann der Ausgangsanschluss einen niedrigen Level ausgibt;
in einer zweiten Phase, wenn der Signaleingangsanschluss bei einem niedrigen Level ist, der Taktretardierungssignaleingangsanschluss bei einem niedrigen Level ist und der Taktsignaleingangsanschluss bei einem hohen Level ist, dann der Ausgangsanschluss ein hohes Level ausgibt;
in einer dritten Phase, wenn der Signaleingangsanschluss bei einem niedrigen Level ist, der Taktretardierungssignaleingangsanschluss bei einem hohen Level ist und der Taktsignaleingangsanschluss bei einem niedrigen Level ist und der Rückstellsignaleingangsanschluss bei einem hohen Level ist, dann der Ausgangsanschluss einen niedrigen Level ausgibt;
in einer vierten Phase, wenn der Signaleingangsanschluss bei einem niedrigen Level ist, der Taktretardierungssignaleingangsanschluss bei einem niedrigen Level ist und der Taktsignaleingangsanschluss bei einem hohen Level ist, dann der Ausgangsanschluss einen niedrigen Level ausgibt; und
in einer fünften Phase, wenn der Signaleingangsanschluss bei einem niedrigen Level ist, der Taktretardierungssignaleingangsanschluss bei einem hohen Level ist, und der Taktsignaleingangsanschluss bei einem niedrigen Level ist, dann der Ausgangsanschluss einen hohen Level ausgibt;
wobei, nach der ersten Phase, die zweiten, dritten, vierten und fünften Phasen in Folge auftreten; und
nachfolgend zu der fünften Phase, sich die vierte Phase und die fünfte Phase wiederholen, bis wieder die erste Phase auftritt.

4. Gate-Treiber, umfassend das Schieberegister gemäß Anspruch 2 oder 3.

5. Array-Substrat, beinhaltend ein Substrat, ein aktives Array, das in dem Anzeigebereich auf dem Substrat angeordnet ist, und den Gate-Treiber gemäß Anspruch 4, angeordnet auf einer Seite des Substrates.

6. Anzeigevorrichtung, beinhaltend das Array-Substrat gemäß Anspruch 5.

## Revendications

1. Un circuit de commande comprenant :
un module d'excursion haute, pour fournir un signal de commande à une borne de sortie en fonction d'un potentiel à un noeud d'excursion haute (PU) et d'un signal reçu en entrée d'une borne d'entrée de signal d'horloge ;
un module de commande d'excursion haute, pour commander le potentiel au noeud d'excursion haute (PU) pour commander le module d'excursion haute en fonction d'un signal reçu en entrée d'une borne d'entrée de signal et d'un signal reçu en entrée d'une borne d'entrée de signal de retardement d'horloge ;
un premier module d'excursion basse, pour tirer vers le niveau bas le potentiel au noeud d'excursion haute (PU) et un potentiel à la borne de sortie en fonction du signal reçu en entrée de la borne d'entrée de signal de retardement d'horloge et d'un potentiel à un premier noeud d'excursion basse (PD1) ;
un deuxième module d'excursion basse, pour tirer vers le niveau bas le potentiel au noeud d'excursion haute (PU) et le potentiel à la borne de sortie en fonction du signal reçu en entrée de la borne d'entrée de signal d'horloge lorsque le signal reçu en entrée de la borne d'entrée de signal est à un niveau bas ;
un module de commande d'excursion basse, pour commander le potentiel au premier noeud d'excursion basse (PD1) pour commander le premier module d'excursion basse en fonction du signal reçu en entrée de la borne d'entrée de signal de retardement d'horloge et du potentiel au noeud d'excursion haute (PU) ;
un module de réinitialisation, pour tirer vers le niveau bas le potentiel au noeud d'excursion haute (PU) et le potentiel à la borne de sortie en fonction d'un signal reçu en entrée d'une borne d'entrée de signal de réinitialisation ;
dans lequel le circuit de commande est configuré de manière que, lorsque le signal reçu en entrée de la borne d'entrée de signal est à un niveau haut, le signal reçu en entrée de la borne d'entrée de signal de retardement d'horloge soit également à un niveau haut, et le signal reçu en entrée de la borne d'entrée de signal d'horloge et celui reçu en entrée de la borne d'entrée de signal de retardement d'horloge soient en opposition de phase ; dans lequel
le premier module d'excursion basse comprend un premier transistor à couche mince TFT d'excursion basse (M10) et un deuxième TFT d'excursion basse (M11), dans lequel le premier transistor à couche mince TFT d'excursion basse (M10) et le deuxième TFT d'excursion basse (M11) sont commandés par le premier noeud d'excursion basse (PD1), et lorsque le premier noeud d'excursion basse (PD1) est à un niveau haut, les premier et deuxième TFT d'excursion basse (M10, M11) sont rendus passants de manière que le noeud d'excursion haute (PU) et la borne de sortie soient tirés vers le niveau bas ;
le deuxième module d'excursion basse comprend en outre : un troisième TFT d'excursion basse (M14), un quatrième TFT d'excursion basse (M7), un cinquième TFT d'excursion basse (M15) et un condensateur (C2), dans lequel le troisième TFT d'excursion basse (M14) comprend une grille reliée au noeud d'excursion haute (PU), un drain relié à un deuxième noeud d'excursion basse (PD2), et une source reliée à une borne d'entrée de signal de blocage ; une première plaque du condensateur (C2) est reliée au deuxième noeud d'excursion basse (PD2), et une deuxième plaque du condensateur (C2) est reliée à la borne d'entrée de signal d'horloge ; le quatrième TFT d'excursion basse (M7) a une grille reliée au deuxième noeud d'excursion basse (PD2), un drain relié au noeud d'excursion haute (PU) et une source reliée à la borne d'entrée de signal de blocage ; et le cinquième TFT d'excursion basse (M15) a une grille reliée au deuxième noeud d'excursion basse (PD2), un drain relié à la borne de sortie et une source reliée à la borne d'entrée de signal de blocage ;
dans lequel le circuit de commande est en outre configuré de telle manière que, lorsque la borne d'entrée de signal fournit en entrée un niveau haut, le potentiel au noeud d'excursion haute (PU) soit tiré vers le niveau haut et le potentiel au premier noeud d'excursion basse (PD1) soit tiré vers le niveau bas, le premier TFT d'excursion basse (M10) et le deuxième TFT d'excursion basse (M11) soient bloqués, le troisième TFT d'excursion basse (M14) soit passant de manière à tirer vers le niveau bas le potentiel au deuxième noeud d'excursion basse (PD2) et à bloquer les quatrième et cinquième TFT d'excursion basse (M7, M15) ; lorsque la borne d'entrée de signal fournit en entrée un niveau bas et la borne d'entrée de signal d'horloge fournit en entrée un niveau haut, le noeud d'excursion haute (PU) soit maintenu à un niveau haut et le troisième TFT d'excursion basse (M14) soit maintenu passant, de manière à maintenir le deuxième noeud d'excursion basse (PD2) à un niveau bas et à bloquer les quatrième et cinquième TFT d'excursion basse (M7, M15) ; la borne d'entrée de signal de retardement d'horloge fournit en entrée un niveau bas, et le premier noeud d'excursion basse (PD1) est maintenu à un niveau bas, et les premier et deuxième TFT d'excursion basse (M10, M11) sont maintenus bloqués ;
après cela le circuit de commande est configuré en outre de telle manière que, chaque fois que la borne d'entrée de signal d'horloge fournit en entrée un niveau haut, le potentiel au deuxième noeud d'excursion basse (PD2) soit chargé via le condensateur (C2) de manière à rendre passant les quatrième et cinquième TFT d'excursion basse (M7, M15) et que le potentiel du noeud d'excursion basse (PU) et à tirer le potentiel de la borne de sortie (PD1) vers le niveau bas ; entre temps, le premier noeud d'excursion basse (PD1) est tirer vers le niveau bas de manière à bloquer les quatrième et cinquième TFT d'excursion basse (M7, M15).

2. Un registre à décalage comprenant les circuits de commande selon la revendication 1 à plusieurs étages, dans lequel un signal reçu en entrée de la borne d'entrée de signal du circuit de commande à chaque étage est un signal fournit par la borne de sortie du circuit de commande à l'étage précédent, et un signal reçu en entrée de la borne d'entrée de signal de réinitialisation du circuit de commande à chaque étage est un signal délivré par la borne de sortie du circuit de commande à l'étage suivant.

3. Le registre à décalage selon la revendication 2, dans lequel, pour le circuit de commande à chaque étage, le registre à décalage est configuré de manière que,
dans une première phase, lorsque la borne d'entrée de signal est à un niveau haut, la borne d'entrée de signal de retardement d'horloge est à un niveau haut, et la borne d'entrée de signal d'horloge est à un niveau bas, la borne de sortie délivre alors un niveau bas ;
dans une deuxième phase, lorsque la borne d'entrée de signal est à un niveau bas, la borne d'entrée de signal de retardement d'horloge est à un niveau bas, et la borne d'entrée de signal d'horloge est à un niveau haut, la borne de sortie délivre alors un niveau haut ;
dans une troisième phase, lorsque la borne d'entrée de signal est à un niveau bas, la borne d'entrée de signal de retardement d'horloge est à un niveau haut, la borne d'entrée de signal d'horloge est à un niveau bas, et la borne d'entrée de signal de réinitialisation est à un niveau haut, la borne de sortie délivre alors un niveau bas ;
dans une quatrième phase, lorsque la borne d'entrée de signal est à un niveau bas, la borne d'entrée de signal de retardement d'horloge est à un niveau bas et la borne d'entrée de signal d'horloge est à un niveau haut, la borne de sortie délivre alors un niveau bas ; et
dans une cinquième phase, lorsque la borne d'entrée de signal est à un niveau bas, la borne d'entrée de signal de retardement d'horloge est à un niveau haut, et la borne d'entrée de signal d'horloge est à un niveau bas, la borne de sortie délivre alors un niveau bas,
dans laquelle, après la première phase, les deuxième, troisième, quatrième et cinquième phases apparaissent dans l'ordre ; et
après la cinquième phase, la quatrième phase et la cinquième phase se répètent jusqu'à ce que la première phase réapparaisse.

4. Un circuit d'attaque de grille, comprenant le registre à décalage selon la revendication 2 ou 3.

5. Un substrat de réseau, comprenant un substrat, un réseau actif agencé dans la zone d'affichage sur le substrat, et le circuit d'attaque de grille selon la revendication 4 agencé sur un côté du substrat.

6. Un dispositif d'affichage comprenant le substrat de réseau selon la revendication 5.
